# EUROPEAN PATENT APPLICATION

(11) **EP 0 658 074 A1**
(43) Date of publication of application: **14.06.1995**
(21) Application number: 94203481.0
(22) Date of filing: 30.11.1994
(51) Int. Cl.: H05K 3/34

(54) **Assembly of a printed circuit board and at least one component, and method of fastening a component to a printed circuit board**

(30) Priority: 06.12.1993 BE 9301340
(71) Applicant: PHILIPS ELECTRONICS N.V., 5621 BA Eindhoven (NL)
(72) Inventor: Ermes, Adrien Charles, c/o Int.Octrooibureau B.V., NL-5656 AA Eindhoven (NL)
(74) Representative: Bos, Kornelis Sjoerd

(57) **Abstract**

A method, and an assembly comprising a printed circuit board (1) and at least one component (4), a connection leg (3) of the component being wave-soldered to the printed circuit board (1), while any excess solder between adjacent connection legs (3) and between a connection leg (3) and the printed circuit board (1) is prevented in that the connection leg (3) lies against the printed circuit board (1) or in that the connection leg (3) comprises an end portion (7) connected to the printed circuit board (1) and an intermediate portion (8) situated between the end portion (7) and the envelope (5), while at least a side of the intermediate portion (8) remote from the printed circuit board (1) is solder-repellent.

## Description

The invention relates to an assembly of a printed circuit board and at least one component, which component is provided with an envelope and at least one connection leg projecting from the envelope and connected to the printed circuit board by means of wave soldering.

The invention also relates to another, similar assembly and to a method of fastening a component to a printed circuit board.

In such an assembly, known from US-A 4796796, and such a method, components are fastened to a printed circuit board with glue before the printed circuit board with the components glued thereto are passed through a wave of solder. During soldering of components with connection legs situated at a comparatively small distance from one another in this manner, connections are also created between the connection legs of one and the same component and between connection legs of components situated next to one another owing to the uncontrollable, comparatively large quantity of solder which is passed along the connection legs. The solder adheres to the entire connection leg and is also caught between the connection legs. After the printed circuit board has been passed through the wave, the solder contracts owing to its surface tension. The contraction causes an agglomeration of solder. If an agglomeration of solder touches two adjacent connection legs, a bridge will be formed between the connection legs.

The invention has for its object to provide an assembly in which components with connection legs situated at a comparatively small distance from one another are connected to a printed circuit board by wave soldering, while electrical interconnections between the connection legs are prevented.

The assembly according to the invention is for this purpose characterized in that the connection leg comprises an end portion connected to the printed circuit board and an intermediate portion situated between the end portion and the envelope, at least a side of the intermediate portion remote from the printed circuit board being free from solder.

This is achieved in that, before wave soldering, it is ensured that the end portion attracts solder and the side of the intermediate portion remote from the printed circuit board repels solder. The intermediate portion limits the height of the solderable portion of the connection leg measured from the printed circuit board. Since solder adheres to the end portion only, and not to the side of the intermediate portion remote from the printed circuit board, the quantity of solder adhering to a connection leg in the soldering wave and caught between the connection legs is limited, and there will be substantially no bridges between the connection legs. The number of bridges which could nevertheless arise is much lower than in the known assemblies. Any bridges are detected by means of a test, upon which they are removed or the entire component is replaced. The other sides of the intermediate portions are screened from the soldering wave by the sides of the intermediate portions remote from the printed circuit board, as a result of which substantially the entire intermediate portion is free from solder. The quantity of solder which nevertheless adheres to the intermediate portion is so small that bridge formation substantially does not occur.

It is noted that Japanese Patent Application 1-61089 discloses components whose connection legs are provided with a protective layer. The components are fastened to the printed circuit board by means of reflow soldering, in which process solder already provided on the printed circuit board is melted once more. The protective layer on the connection legs of the components ensures that the solder present on the printed circuit board does not creep along the connection legs to the envelope of the component, whereby insufficient solder would remain to achieve a good connection between the printed circuit board and the connection leg.

It is noted that it is visible on the assembly whether the components were fastened by wave soldering or by reflow soldering to the printed circuit board. In reflow soldering, the shape of the solder is substantially identical for all connection legs. In wave soldering, it is visible from the shape of the solder how the assembly was moved through the solder wave, because the shape of the solder at one side of the component is different from that at an opposite side.

An embodiment of the assembly according to the invention is characterized in that the entire intermediate portion is solder-repellent.

As a result of this, solder can adhere to the end portion only, and possibly to a section situated between the envelope and the intermediate portion.

Another embodiment of the assembly according to the invention is characterized in that the intermediate portion projects from the envelope.

As a result, solder can adhere substantially only to the end portion of the connection leg.

A further embodiment of the assembly according to the invention is characterized in that the intermediate portion is provided with a solder-repellent protective layer.

A connection leg manufactured from a material to which solder adheres well is thus provided with an intermediate portion to which solder does not adhere.

A yet further embodiment of the assembly according to the invention is characterized in that the end portion is provided with a solder-attracting coating.

A connection leg manufactured from a material to which solder does not adhere well is thus provided with an end portion to which solder does adhere well.

A still further embodiment of the assembly according to the invention is characterized in that the distance from the intermediate portion to the printed circuit board is a minimum.

It was found that, the smaller the maximum distance between the printed circuit board and a portion of the connection leg yet to be soldered, the smaller the risk of bridges being formed between the connection legs.

This effect is utilized in another assembly according to the invention which is characterized in that the entire connection leg lies against the printed circuit board.

In this assembly according to the invention, the intermediate portion necessary in the previous assembly for minimizing the height of the solderable portion of the connection leg is redundant. Since the connection leg lies against the printed circuit board, no excess solder can be caught between the connection leg and the printed circuit board, whereby bridge formation is prevented.

An embodiment of the assemblies according to the invention is characterized in that the interspacing S between the connection legs obeys the relation 0.2 ≦ S ≦ 1 mm.

Components with connection legs provided with a protective layer or lying against the printed circuit board, with an interspacing S between the connection legs of less than 1 mm, can be fastened to the printed circuit board by means of wave soldering. In the known assemblies, bridges are often formed between the connection legs with such an interspacing.

The invention also has for its object to provide a method by which the disadvantages of the known method are avoided.

The method according to the invention for fastening a component to a printed circuit board, which component is provided with an envelope and with at least one connection leg projecting from the envelope and connected to the printed circuit board by means of wave soldering, is for this purpose characterized in that the connection leg comprises an end portion connected to the printed circuit board and an intermediate portion situated between the end portion and the envelope, a solder-repellent protective layer being provided on at least a side of the intermediate portion remote from the printed circuit board, whereupon the component is fastened to the printed circuit board by wave soldering.

The formation of bridges is prevented in that a protective layer to which no solder adheres during wave soldering is provided on the intermediate portion. The protective layer may be removed from the connection leg after wave soldering.

The invention will be explained in more detail with reference to the drawing in which
Fig. 1 shows a first embodiment of a printed circuit board with a component fastened thereon according to the invention,
Fig. 2 shows a detail of the component of Fig. 1,
Fig. 3 shows a second embodiment of a printed circuit board with a component fastened thereon according to the invention,
Fig. 4 shows a third embodiment of a printed circuit boad with a component fastened thereon according to the invention, and
Fig. 5 is a cross-section of a connection leg.

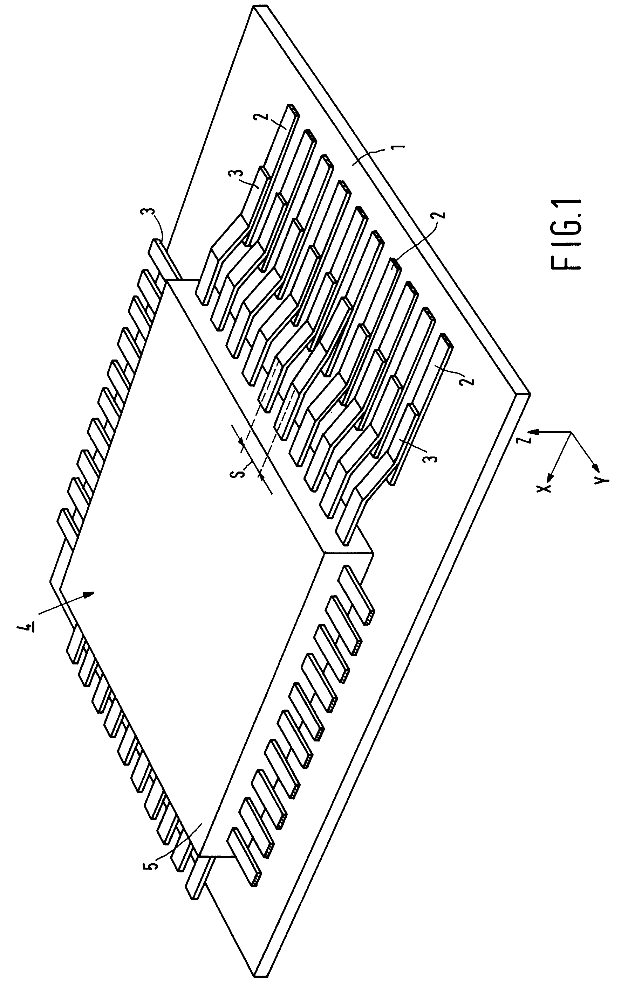

Fig. 1 shows a printed circuit board 1 provided with a pattern of tracks 2 on which connection legs 3 of a component 4 have been fastened by wave soldering. The component 4 is further provided with an envelope 5 and connection legs 3 projecting from the envelope 5.

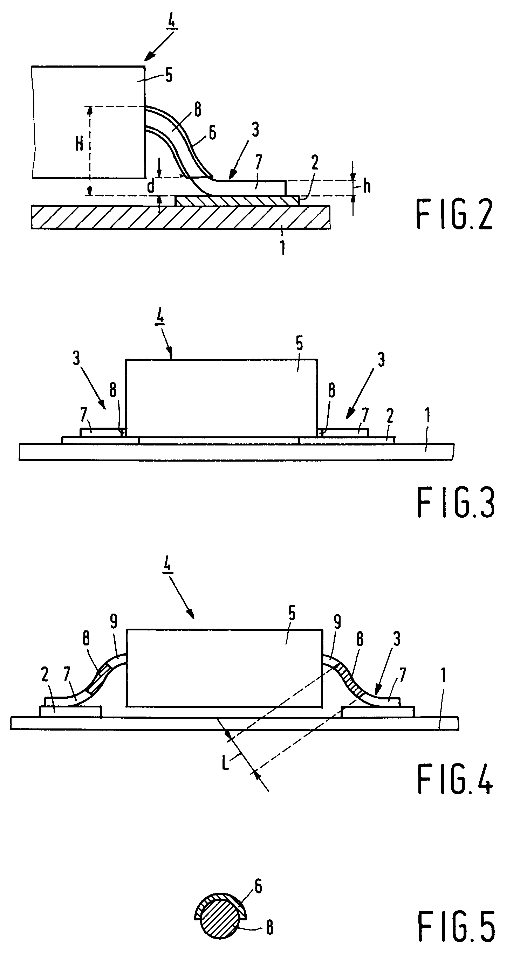

Fig. 2 shows a detail of the component 4 shown in Fig. 1. The connection leg 3 comprises an end portion 7 and an intermediate portion 8 connected to the end portion 7 and to the envelope 5. The intermediate portion 8 is provided with a solder-repellent protective layer 6 over its entire circumference from the envelope 5 up to a distance d from the pattern of tracks 2, so that no solder will adhere to the protective layer 6 and the intermediate portion 8 during wave soldering of the component 4. The distance d from the intermediate portion 8 to the pattern of tracks 2 is preferably equal to the thickness h of the connection leg 3 measured transverse to the plane of the printed circuit board 1. As a result, only that portion of the connection leg 3 which is in contact with the printed circuit board 1 is provided with solder.

In experiments, components 4 with an interspacing S between the connection legs 3 of 0.3, 0.4, and 0.65 mm were wave-soldered to the printed circuit board 1, upon which the number of bridges between the connection legs was found to be considerably less than in the case of wave soldering of the same components without protective layers on the intermediate portions, with solder being present on the connection leg 3 over the entire height h of the connection leg 3.

Fig. 3 shows a second embodiment of an assembly according to the invention of a printed circuit board 1 with a component 4 fastened thereto. The component 4 is provided with a connection leg 3 which lies against the printed circuit board 1 over its entire length. The distance d from the intermediate portion 8 to the printed circuit board is a minimum here, so that no access is available anymore for solder between the connection leg and the printed circuit board or pattern of tracks 2 as seen in a plane perpendicular to the direction of transport of the printed circuit board 1 through the solder wave. With such a component 4, the intermediate portion 8 is in fact unnecessary and can be omitted, so that the end portion 7 projects directly from the envelope 5.

Fig. 4 shows a third embodiment of an assembly according to the invention provided with a printed circuit board 1 with a component 4 fastened thereto. The connection leg 3 of the component 4 comprises an end portion 7, an intermediate portion 8, and a section 9 situated between the intermediate portion 8 and the envelope. The intermediate portion 8 is provided with a protective layer 6 to which no solder adheres. The section 9 is created in that the protective layer 6 is provided on the central portion of the connection leg 3 only. Also with this component 4, the formation of bridges between connection legs is prevented, provided that the length L of the intermediate portion 8 between the end portion 7 and the section 9 is sufficiently great and the length of the section 9 sufficiently small. Experiments have shown that substantially no bridges are formed between the connection legs 3 in the case of a length L which is greater than the interspacing S.

Fig. 5 is a cross-section of an intermediate portion 8 of a connection leg 3 of the component 4 shown in Fig. 4. The intermediate portion 8 is provided with a protective layer 6 over half its circumference at a side facing away from the printed circuit board. During wave soldering, the protective layer 6 acts as a shield for the unprotected portion of the intermediate portion 8, so that no solder adheres substantially to the entire circumference of the intermediate portion 8. The protective layer 6 may be provided on the connection legs 3 with a brush after the component 4 has been placed on the printed circuit board 1. The protective layer may alterantively be provided on the connection legs by means of printing techniques with stamp pads. The protective layer may be, for example, a glue which cures under UV radiation (such as an acrylate-based glue) or a solder resist which is normally used for screening printed circuit boards against solder.

Instead of providing the intermediate portion 8 with a protective layer 6 to which no solder adheres, it is alternatively possible to provide the end portion 7 of a connection leg 3 to which no solder adheres with a coating to which solder does adhere. The intermediate portion then remains free from solder of its own accord. The coating may be, for example, a tin layer.

After the components have been soldered to the printed circuit board, it is checked whether any bridges have been formed nevertheless between connection legs. Any bridges are removed, or the entire component is replaced.

The protective layer or coating may be provided on the connection legs in that the component is partly immersed in a liquid.

The envelope of the component may be a temporary one, for protecting the component during wave soldering, or a permanent one, in which case the envelope is a housing of the component.

## Claims

1. An assembly of a printed circuit board and at least one component, which component is provided with an envelope and at least one connection leg projecting from the envelope and connected to the printed circuit board by means of wave soldering, characterized in that the connection leg comprises an end portion connected to the printed circuit board and an intermediate portion situated between the end portion and the envelope, at least a side of the intermediate portion remote from the printed circuit board being free from solder.

2. An assembly as claimed in Claim 1, characterized in that the entire intermediate portion is solder-repellent.

3. An assembly as claimed in Claim 1 or 2, characterized in that the intermediate portion projects from the envelope.

4. An assembly as claimed in Claim 1, 2 or 3, characterized in that the intermediate portion is provided with a solder repellent protective layer.

5. An assembly as claimed in Claim 1, 2, 3 or 4, characterized in that the end portion is provided with a solder-attracting coating.

6. An assembly as claimed in any one of the preceding Claims, characterized in that the distance from the intermediate portion to the printed circuit board is a minimum.

7. An assembly of a printed circuit board and at least one component, which component is provided with an envelope and at least one connection leg projecting from the envelope and connected to the printed circuit board by means of wave soldering, characterized in that the entire connection leg lies against the printed circuit board.

8. An assembly as claimed in any one of the preceding Claims, characterized in that the interspacing S between the connection legs obeys the relation 0.2 ≦ S ≦ 1 mm.

9. A method of fastening a component to a printed circuit board, which component is provided with an envelope and with at least one connection leg projecting from the envelope and connected to the printed circuit board by means of wave soldering, characterized in that the connection leg comprises an end portion connected to the printed circuit board and an intermediate portion situated between the end portion and the envelope, a solder-repellent protective layer being provided on at least a side of the intermediate portion remote from the printed circuit board, whereupon the component is fastened to the printed circuit board by wave soldering.
